Europäisches Patentamt

**European Patent Office**

**Office européen des brevets**

(11) Numéro de publication: **0 273 792 B1**

## (12) FASCICULE DE BREVET EUROPEEN

(45) Date de publication de fascicule du brevet: **09.09.92**  (51) Int. Cl.5: **H01L 21/00**, H01L 21/28

(21) Numéro de dépôt: **87402668.5**

(22) Date de dépôt: **25.11.87**

(54) **Procédé de réalisation sur un substrat d'éléments espacés les uns des autres.**

(30) Priorité: **28.11.86 FR 8616651**

(43) Date de publication de la demande:
**06.07.88 Bulletin 88/27**

(45) Mention de la délivrance du brevet:
**09.09.92 Bulletin 92/37**

(84) Etats contractants désignés:
**DE FR GB NL**

(56) Documents cités:
**EP-A- 0 111 086
EP-A- 0 114 133
US-A- 4 551 905**

**IBM TECHNICAL DISLCOSURE BULLETIN, vol.
24, no. 6, novembre 1981, pages 2964-2965,
New York, US; S.D. EMMANUEL: "Low temperature lift-off process"**

**PATENT ABSTRACTS OF JAPAN, vol. 10, no.
121, 7 mai 1986, page 84 E 401; & JP-A-60 254
733**

**MICROELECTRONIC ENGINEERING, vol. 3, no.
1/4, décembre 1985, pages 499-505, Elsevier
Science Publishers B.V., Amsterdam, NL;
H.J. GEELEN et al.: "Polyimide lift off for

submicrometer metallisation patterns"**

(73) Titulaire: **COMMISSARIAT A L'ENERGIE ATO-
MIOUE Etablissement de Caractère Scientifique Technique et Industriel
31/33, rue de la Fédération
F-75015 Paris(FR)**

(72) Inventeur: **Sibuet, Henri
4, rue Fétola Le Fontanil
F-38120 Saint Egrève(FR)**

(74) Mandataire: **Mongrédien, André et al
c/o BREVATOME 25, rue de Ponthieu
F-75008 Paris(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

# Description

La présente invention concerne un procédé de réalisation sur un substrat d'éléments espacés les uns des autres.

L'invention s'applique à la réalisation de conducteurs électriques sur un substrat isolant, notamment pour la micro-électronique, par exemple pour la fabrication de têtes d'enregistrement magnétiques en technologie intégrée, tel que décrit dans les documents : EP-A-0 152 326 et EP-A-0 152 328.

De façon connue, pour réaliser des éléments tels que des conducteurs électriques espacés les uns des autres sur un substrat, on dépose par exemple sur le substrat une couche d'un matériau conducteur que l'on grave à travers un masque de motifs appropriés de façon à obtenir lesdits conducteurs ou alors on dépose sur le substrat par dessus un masque de motifs appropriés réalisé sur le substrat, la couche de matériau conducteur, le masque étant ensuite éliminé entraînant avec lui les parties de la couche de matériau conducteur déposées sur celui-ci.

Quel que soit le procédé mis en oeuvre pour réaliser des éléments, celui-ci nécessite l'utilisation d'un masque présentant des motifs géométriques dont les dimensions sont fonction de celles des éléments à réaliser. Ainsi, par exemple, dans le cas où l'on veut réaliser des éléments faiblement espacés, par exemple pour la micro-électronique, les procédés connus doivent comporter la réalisation de masques présentant des motifs de faibles largeurs. La mise en oeuvre de ces masques est d'autant plus difficile que ces largeurs sont faibles et inférieures au micron.

Par ailleurs, on connaît déjà, dans les techniques de fabrication de structures électroniques submicroniques des procédés de gravures qui utilisent, comme étape intermédiaire de la fabrication, le recours à des espaceurs, sortes de petits murets de très faible épaisseur implantés perpendiculairement à la surface d'un substrat sur lequel on réalise la structure désirée.

C'est le cas, par exemple, des réalisations décrites dans les documents EP-A-0 111 086 (notamment figures 1B, 2B et 6) et JP-A-60 254 733 (figures a, b, c, d, e et f). Dans ces documents, les espaceurs sont utilisés pour la fabrication de masques de formes particulières (voir figures 1C et 1D du brevet européen EP-A-0 111 086 et figures d et e du brevet JP-A-60 254 733) par recouvrement complet des espaceurs à l'aide du matériau constituant le masque et élimination de ces espaceurs à l'aide d'une étape complémentaire de planarisation de la structure permettant la mise à nu puis l'ablation de ces mêmes espaceurs.

Cet état de la technique antérieure, relatif à la fabrication de masques en particulier en photorésines et nécessitant une étape de planarisation difficile à réaliser avec un matériau conducteur, ne peut donc servir d'enseignement à l'homme de métier pour le dépôt, sur un substrat, d'éléments conducteurs espacés d'intervalles de dimensions submicroniques.

Une autre technique de fabrication d'éléments espacés sur un substrat est connue par le document IBM Technical Disclosure Bulletin, vol. 24, n° 6, novembre 1981, pages 2964-2965 qui décrit un procédé pour déposer un métal à basse température avec une bonne adhésion sur des structures de type lift off. On réalise d'abord par gravure sur un substrat un masque photorésistant comportant des talus à pente négative que l'on recouvre d'une première barrière métallique uniforme (fig. 1 et 2). Un second métal destiné à subsister sous forme de plots espacés est alors déposé sur le premier (Fig. 3) puis l'on dissout finalement le masque photorésistant et la première couche métallique partout où elle n'est pas protégée par le second métal pour obtenir les plots espacés du second métal (fig. 4). Cette technique qui utilise une pulvérisation isotrope de la première barrière métallique et un dépôt par évaporation du second métal ne permet pas toutefois d'utiliser la forme des dépôts du second métal sur le masque photorésistant pour empêcher son propre dépôt sur les parois des talus.

Néanmoins, le demandeur a trouvé, de façon inattendue, que la technique de réalisation des espaceurs pouvait, si on l'associe d'une manière différente en combinaison avec celle des dépôts anisotropes, permettre la réalisation sur un substrat d'éléments espacés les uns des autres en s'affranchissant des inconvénients de l'art antérieur, et notamment la réalisation d'éléments séparés par une distance inférieure à 1 $\mu$m.

De façon plus précise, l'invention a pour objet un procédé de réalisation sur un substrat, d'éléments espacés les une des autres, comportant une première étape de réalisation sur le substrat d'espaceurs (10), perpendiculaires au substrat sous forme de petits murets dont les faces sont planes et parallèles, dont les dimensions et les espacements sont fonction des dimensions et de l'espacement des éléments (11a, 13a) à réaliser, caractérisé en ce que l'on effectue ensuite sur le substrat (1) un dépôt anisotrope dans une direction perpendiculaire à la surface du substrat (1), d'au moins un premier matériau constituant les éléments (11a), de façon à ce que le dépôt (11b) réalisé sur les têtes des espaceurs (10) s'oppose au dépôt de ce même premier matériau sur les parois des espaceurs en ce sens qu'il présente une section de forme ovale et de largeur supérieure à l'épaisseur des espaceurs (10), les parois du dépôt (11a) présentant de ce fait une pente inclinée sur la verticale, fonction de la forme ovale des dépôts (11b), puis on élimine les espaceurs.

On entend par dépôt anisotrope, un dépôt s'effectuant de façon préférentielle suivant une direction privilégiée de l'espace, c'est-à-dire dans le cas particulier de l'invention, dans une direction perpendiculaire à la surface du substrat.

De façon avantageuse, les dépôts anisotropes sont réalisés par évaporation sous vide, par exemple avec un vide de l'ordre de $10^{-4}$ Pascal ($10^{-6}$ Torr).

On voit que le procédé objet de l'invention utilise les espaceurs, en soi connus, d'une manière originale et entièrement nouvelle qui consiste, en les associant à un dépôt fait de façon anisotrope selon la direction normale à la paroi du substrat, à utiliser le dépôt sur les têtes des espaceurs comme écran protecteur pour empêcher ce dépôt d'atteindre les parois des espaceurs.

De façon avantageuse, l'élimination des espaceurs s'effectue par gravure chimique de ces espaceurs.

Avec le procédé de l'invention, on peut réaliser des éléments espacés d'une distance inférieure à 1 µm en réalisant des espaceurs de largeur inférieure à 1 µm.

De façon avantageuse, pour réaliser les espaceurs, on effectue les étapes suivantes :

- réalisation sur le substrat d'un masque présentant des motifs géométriques fonction des dimensions et de l'espacement des espaceurs à réaliser,
- dépôt isotrope par dessus ledit masque, d'une couche du matériau constituant lesdits espaceurs,
- gravure anisotrope de ladite couche de façon à ne laisser subsister de ce dépôt que les parties de la couche perpendiculaires au plan du substrat et situées contre les parois du masque, les espaceurs étant constitués par cesdites parties, et
- élimination du masque.

Le procédé de l'invention permet de réaliser des espaceurs dont la largeur peut atteindre jusqu'à 0,3 µm.

On entend par dépôt isotrope un dépôt s'effectuant suivant toutes les directions de l'espace. Ce dépôt isotrope présente une épaisseur du même ordre de grandeur que la largeur des espaceurs à réaliser.

Par dépôt anisotrope, on entend une gravure s'effectuant de façon préférentielle suivant une direction privilégiée de l'espace, c'est-à-dire dans le cas de l'invention, suivant une direction perpendiculaire à la surface du substrat.

L'élimination du masque peut s'effectuer aussi bien par une gravure chimique que par une gravure ionique réactive.

Au cours du dépôt anisotrope sur le substrat du premier matériau, si ce dépôt n'est pas suffisamment directif, le premier matériau peut néanmoins se déposer sur la base des espaceurs ; selon l'invention, on réalise alors de façon avantageuse un dépôt anisotrope perpendiculaire au substrat d'un second matériau sur le dépôt de premier matériau de façon à ce qu'il recouvre la surface supérieure du dépôt de premier matériau et on grave le premier matériau de façon à l'éliminer au moins sur la base des espaceurs.

Cette étape du procédé permet de dégager la base des espaceurs de tout matériau, pour faciliter l'élimination ultérieure des espaceurs.

Selon un mode préféré de réalisation, les éléments étant des conducteurs électriques, le premier matériau est conducteur et le substrat est isolant. Lorsque l'on réalise un dépôt d'un deuxième matériau, ce dernier peut être aussi bien conducteur qu'isolant mais de façon préférentielle pour réaliser des éléments conducteurs, on utilise un deuxième matériau conducteur.

De façon avantageuse, les espaceurs sont réalisés en silice, l'élimination de ces espaceurs s'effectuant alors par exemple par une solution d'acide fluorhydrique (HF).

Selon un mode de mise en oeuvre, le masque est réalisé par dépôt d'une couche de résine polymérisable, suivant une épaisseur du même ordre de grandeur que la hauteur des espaceurs à réaliser, par polymérisation de cette couche de résine, puis par gravure anisotrope de cette couche de façon à obtenir les motifs dudit masque.

Bien entendu, ce masque peut être réalisé par d'autres matériaux à condition que ces matériaux puissent être gravés de façon anisotrope et sélectivement par rapport au substrat.

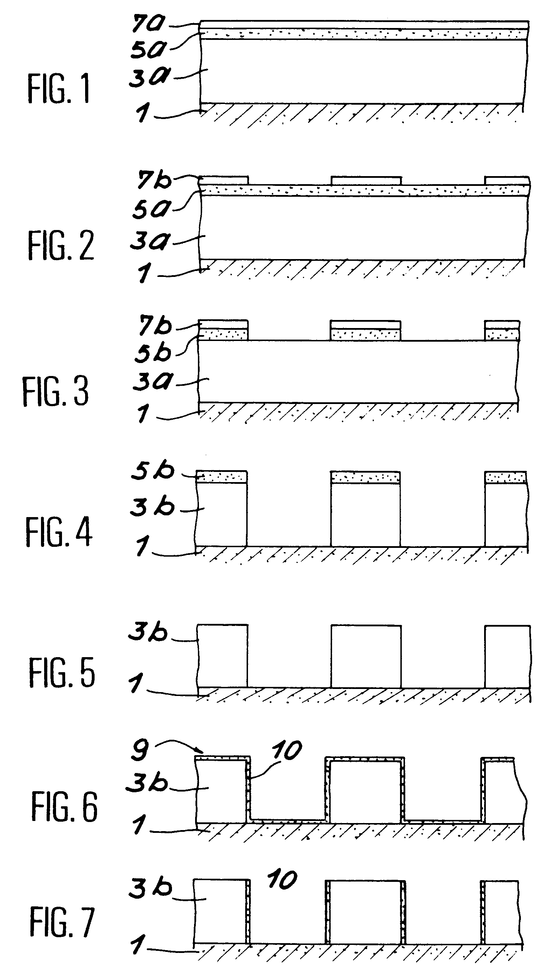

D'autres caractéristiques et avantages de l'invention ressortiront mieux de la description qui va suivre, donnée à titre purement illustratif et non limitatif, en référence aux figures 1 à 13 annexées, dans lesquelles :

- les figures 1 à 12 représentent schématiquement, en coupe, les principales étapes de réalisation sur un substrat d'éléments espacés les uns des autres, conformément au procédé de l'invention, ces éléments étant réalisés par dépôt d'un premier et d'un second matériau, et

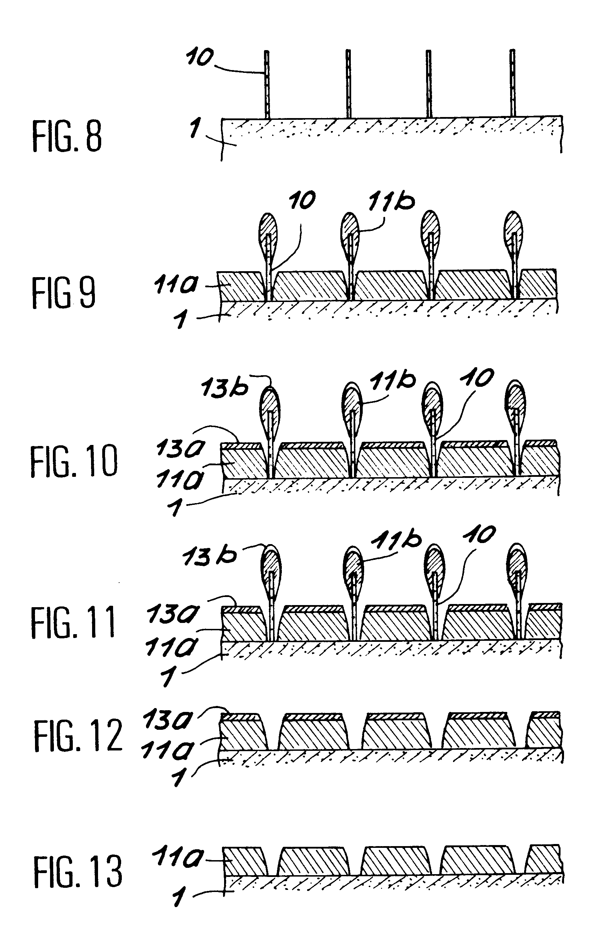

- la figure 13 représente schématiquement également en coupe, des éléments constitués par un seul matériau, réalisés sur un substrat.

On a choisi de représenter pour plus de clarté ces figures en coupe dans le sens de la largeur des éléments à réaliser ou réalisés, étant donné que la forme de ces éléments peut être quelconque, et dépend de leur utilisation. Ainsi, ces éléments peuvent être par exemple rectilignes ou comme décrit dans les documents EP-A-0 152 326 et EP-A-0 152 328 en forme de spirale.

Les figures 1 à 5 représentent différentes étapes d'un exemple de réalisation, sur un substrat 1, d'un masque 3b en résine, utilisé conformément à l'invention pour former les espaceurs.

Comme représenté figure 1, pour réaliser ledit masque, on dépose tout d'abord sur ce substrat 1 une couche 3a de résine, d'épaisseur de l'ordre de grandeur de la hauteur des espaceurs à réaliser, que l'on polymérise par un traitement thermique. On dépose ensuite une couche 5a, par exemple de silice et enfin une couche 7a de résine photosensible.

Cette couche 7a de résine est irradiée puis développée de façon à obtenir un masque 7b présentant des motifs géométriques, fonction des dimensions et de l'espacement des espaceurs à réaliser (figure 2).

Ainsi, par exemple, pour réaliser des éléments de l'ordre de 3 $\mu$m de large, espacés d'environ 0,5 $\mu$m, les espaceurs doivent présenter une largeur de l'ordre de 0,5 $\mu$m et être espacés de 3 $\mu$m. Les motifs du masque 7b doivent donc être tels que la largeur des parties du masque 7b en résine sont de l'ordre de 3 $\mu$m et l'espacement entre ces parties de l'ordre de 4 $\mu$m, compte tenu de la largeur des espaceurs.

Les motifs géométriques du masque 7b sont ensuite transférés dans la couche 5a de silice (figure 3), par exemple par une gravure ionique réactive à travers le masque 7b, avec un agent d'attaque sans action sur la résine tel que le trifluorure ou le tétrafluorure de carbone ($CHF_3$ ou $CHF_4$). On obtient ainsi un deuxième masque 5b, en silice.

Ce masque 5b en silice permet ensuite de graver la couche de résine 3a suivant les mêmes motifs géométriques, de façon à obtenir un masque 3b (figure 4). La couche 3a est par exemple attaquée à travers le masque 5b par une gravure ionique réactive avec un agent d'attaque sans action sur la silice tel que l'oxygène. Le masque 7b étant constitué de façon avantageuse par une résine attaquable par le même type de gravure ionique réactive que la couche de résine 3a. Pour que ce masque 7b soit complètement éliminé au cours de cette gravure, l'épaisseur de la couche 7a est choisie de préférence inférieure ou égale à l'épaisseur de la couche 3a. Après cette étape, il ne reste sur le substrat que les masques 3b et 5b (figure 4).

Le masque 5b n'étant plus protégé par le masque 7b, il est à son tour éliminé, par exemple par une gravure ionique réactive avec du trifluorure ou du tétrafluorure de carbone, afin de ne garder sur le substrat que le masque 3b en résine polymérisée (figure 5). Ce masque 3b permet comme représenté sur les figures 6, 7 et 8 de réaliser, conformément à l'invention, les espaceurs.

Ainsi, comme représenté figure 6, on dépose tout d'abord par dessus le masque 3b, une couche 9 du matériau constituant les espaceurs, tel que de la silice. Ce dépôt est réalisé de façon isotrope, pour obtenir une couche d'épaisseur uniforme, cette épaisseur étant du même ordre de grandeur que la largeur des espaceurs à réaliser.

On effectue ensuite une gravure anisotrope de cette couche 9, par exemple par une gravure ionique réactive avec comme agent d'attaque du trifluorure ou du tétrafluorure de carbone pour une couche en silice, afin de ne laisser subsister de cette couche, que les parties 10 perpendiculaires à la surface du substrat et contre les parois du masque 3b (figure 7). La largeur des parties 10 restantes de la couche 9 est pratiquement égale à l'épaisseur de la couche 9 avant cette gravure.

Le masque 3b est ensuite éliminé, par exemple par une gravure chimique ou une gravure ionique réactive avec comme agent d'attaque de l'oxygène, afin de ne conserver sur le substrat que les espaceurs 10 (figure 8).

Les figures 9, 10, 11 et 12 suivantes représentent les étapes finales permettant de mettre en oeuvre les éléments conformément à l'invention.

On réalise tout d'abord un dépôt anisotrope d'un premier matériau sur le substrat, par dessus les espaceurs (figure 9). Lorsque les éléments sont des conducteurs, le premier matériau est par exemple du cuivre. Ce matériau se dépose donc à la fois sur le substrat et sur la partie supérieure des espaceurs réalisant respectivement les dépôts référencés 11a et 11b. Le dépôt 11b réalisé sur la tête des espaceurs présente une section de forme ovale ; il permet au fur et à mesure de sa formation d'éviter que le matériau constituant le dépôt 11a ne s'agglomère contre les parois des espaceurs. Aussi, comme représenté figure 9, les parois du dépôt 11a présentent de ce fait une pente inclinée, de quelques degrés par rapport à la direction verticale des espaceurs, la pente de cette inclinaison dépendant de la forme ovale de la section du dépôt 11b réalisé sur les espaceurs.

Lorsque le dépôt anisotrope est insuffisamment directif, au début de ce dépôt, il peut arriver néanmoins que le premier matériau se dépose contre les parois de l'espaceur, à la base de ces derniers. Aussi, pour permettre l'élimination ultérieure des espaceurs, le matériau ainsi déposé sur la base des espaceurs doit être enlevé.

Pour cela, on met en oeuvre une variante du procédé objet de l'invention dans laquelle on dépose de façon anisotrope un deuxième matériau sur le premier matériau. Lorsque les éléments sont des conducteurs, le deuxième matériau est par exemple du chrome. Ce deuxième matériau se dépose sur les dépôts 11a et 11b du premier matériau réalisant un dépôt 13a au-dessus du substrat et un dépôt 13b au-dessus des espaceurs (figure 10). Le dépôt 11b du premier matériau sur les espaceurs, empêche le deuxième matériau de se déposer sur les espaceurs et au voisinage de la base de ces derniers. Le deuxième matériau ne protège donc pas le dépôt 11a du premier matériau à la base des espaceurs. On grave ensuite de façon sélective, le premier matériau par une attaque chimique par exemple de $H_2SO_4 + CrO_3$ pour du cuivre ou par une attaque ionique réactive avec du gaz chloré de façon à éliminer les parties du premier matériau non protégées par le deuxième matériau, autrement dit situées au voisinage de la base des espaceurs. La base des espaceurs étant ainsi dégagée du premier matériau (figure 11), les espaceurs peuvent être éliminés ainsi que les dépôts 11b et 13b situés sur la tête de ces derniers. L'élimination des espaceurs peut être mise en oeuvre, par exemple par une attaque chimique avec de l'acide fluorhydrique dans le cas d'espaceurs en silice, les dépôts 11b et 13b situés sur leur tête étant entraînés dans le bain d'attaque.

Après cette étape, comme représenté figure 12, il ne reste sur le substrat que les éléments constitués par les dépôts 11a et 13a des premier et deuxième matériaux.

Dans le cas de la réalisation de conducteurs électriques, le premier matériau est conducteur, mais le deuxième matériau peut être aussi bien conducteur qu'isolant, ce dernier servant comme on l'a vu précédemment à protéger le premier matériau lors de son élimination, au voisinage de la base des espaceurs.

La figure 13 représente une variante de la figure 12. Sur cette figure, les éléments situés sur le substrat 1 sont constitués uniquement par un dépôt 11a de premier matériau. La réalisation de ces éléments peut être obtenue, soit par élimination du dépôt 13a du deuxième matériau, soit par un dépôt de premier matériau suffisamment directif pour qu'il ne soit pas nécessaire d'utiliser un deuxième matériau.

A titre d'exemple, pour réaliser des éléments de largeur 3 $\mu$m, espacés les uns des autres par une distance inférieure à 1 $\mu$m, par exemple de l'ordre de 0,5 $\mu$m et d'épaisseur de l'ordre de 0,9 $\mu$m, on dépose sur le substrat une couche de résine 3a de 2 $\mu$m, une couche de silice 5a de 0,1 $\mu$m et une couche de résine 7a de 1 $\mu$m. Comme décrit précédemment, on réalise successivement à partir de ces couches des masques 7b, 5b et 3b dont la largeur des parties non gravées est de l'ordre de 3 $\mu$m et l'espacement entre ces parties de l'ordre de 4 $\mu$m. Seul le masque 3b étant conservé, on dépose par dessus celui-ci une couche 9 par exemple de silice de 0,5 $\mu$m d'épaisseur ; après gravure de la couche 9 et élimination du masque 3b, il ne reste sur le substrat que les parties 10 de la couche 9 constituant les espaceurs. Ces derniers ont donc une largeur de 0,5 $\mu$m, une hauteur de 2 $\mu$m et ils sont espacés les uns des autres d'une distance de 3 $\mu$m. On réalise alors un dépôt 11a de premier matériau sur le substrat suivant une épaisseur de 0,9 $\mu$m. Dans le cas où l'on réalise un dépôt 13a d'un deuxième matériau, celui-ci est effectué sur une faible épaisseur : de l'ordre de 0,03 $\mu$m.

Ces figures représentent la réalisation d'éléments de largeur identique mais bien entendu cet exemple n'est pas limitatif, ces éléments pouvant être de largeur différente. Pour obtenir des éléments de largeur différente, il suffit de réaliser des espaceurs différemment espacés, autrement dit de réaliser un masque 3b dont la largeur des parties recouvrant le substrat varie en fonction de l'espacement désiré des espaceurs.

Le procédé de l'invention permet, comme on l'a vu précédemment, de réaliser des éléments faiblement espacés, ce qui permet de fabriquer sur un substrat de surface déterminé un maximum d'éléments. Cette caractéristique est particulièrement intéressante pour la réalisation de têtes magnétiques, la qualité d'une tête magnétique dépendant directement du nombre de spires de conducteurs présentes entre les pièces polaires. La réalisation d'éléments faiblement espacés permet en outre, lorsqu'on dépose une couche de matériau par dessus ces éléments notamment pour isoler ou protéger ces éléments, d'obtenir un profil pratiquement plan, rendant inutile dans certaines applications la mise en oeuvre d'une étape de planarisation.

Un autre avantage du procédé objet de l'invention réside dans le fait que l'épaisseur du dépôt anisotrope n'est pas limitée ; elle peut être inférieure, égale ou même supérieure à la hauteur des espaceurs et atteindre plusieurs micromètres, ce qui est difficile avec les techniques de lift-off. Seule la pente des bords du dépôt dépend de la hauteur des espaceurs.

Enfin, ce procédé permet de s'affranchir des problèmes de température et de contraintes de dépôt qui sont spécifiques des procédés utilisant des masques de résine.

**Revendications**

1. Procédé de réalisation sur un substrat (1) d'éléments (11a, 13a) espacés les uns des autres, comportant une première étape de réalisation sur le substrat d'espaceurs (10), perpendiculaires au substrat sous forme de petits murets dont les faces sont planes et parallèles, dont les dimensions et les espacements sont fonction des dimensions et de l'espacement des éléments (11a, 13a) à réaliser, caractérisé en ce que l'on effectue ensuite sur le substrat (1) un dépôt anisotrope dans une direction perpendiculaire à la surface du substrat (1), d'au moins un premier matériau constituant les éléments (11a), de façon à ce que le dépôt (11b) réalisé sur les têtes des espaceurs (10) s'oppose au dépôt de ce même premier matériau sur les parois des espaceurs en ce sens qu'il présente une section de forme ovale et de largeur supérieure à l'épaisseur des espaceurs (10), les parois du dépôt (11a) présentant de ce fait une pente inclinée sur la verticale, fonction de la forme ovale des dépôts (11b), puis on élimine les espaceurs.

2. Procédé de réalisation sur un substrat (1) d'éléments (11a, 13b) selon la revendication 1, caractérisé en ce que\les éléments sont conducteurs.

3. Procédé de réalisation sur un substrat (1) d'éléments (11a, 13a) selon la revendication 1, caractérisé en ce que, pour pallier une insuffisance éventuelle d'anisotropie du dépôt du premier matériau provoquant un dépôt au moins partiel de ce dernier sur la base des espaceurs, on réalise perpendiculairement à la surface du substrat (1) un dépôt anisotrope (13a) d'un second matériau sur le dépôt de premier matériau de façon à ce qu'il recouvre la surface supérieure du dépôt de premier matériau et on grave le premier matériau de façon à l'éliminer au moins sur la base des espaceurs (10).

4. Procédé selon l'une quelconque des revendications 1 à 3, caractérisé en ce que les espaceurs sont réalisés en silice.

5. Procédé selon la revendication 4, caractérisé en ce que les espaceurs sont éliminés par l'acide fluorhydrique.

## Claims

1. Process for producing mutually spaced elements (11a, 13a) on a substrate (1), having a first stage of producing on the substrate spacers (10), which are perpendicular to the substrate and which are in the form of small walls, whose faces are planar and parallel and whose dimensions and spacings are a function of the dimensions and spacing of the elements (11a, 13a) to be produced, characterized in that this is followed on substrate (1) by an anisotropic deposition in a direction perpendicular to the surface of the substrate (1) of at least one first material constituting the elements (11a), in such a way that the deposit (11b) produced on the heads of the spacers (10) opposes the deposition of said first material on the walls of the said spacers in the sense that it has oval cross-section with a width greater than the thickness of the spacers (10), the walls of the deposit (11a) consequently having a vertically inclined gradient, which is a function of the oval shape of the deposits (11b), followed by the elimination of the spacers.

2. Process for the production of elements (11a, 13b) on a substrate according to claim 1, characterized in that the elements are conductors.

3. Process for producing elements (11a,, 13a) on a substrate (1) according to claim 1, characterized in that, to obviate a possible inadequacy of the anisotropy of the deposit of the first material bringing about an at least partial deposition of the latter on the base of the spacers, perpendicular to the surface of the substrate (1) is made an anisotropic deposit (13a) of a second material on the deposit of the first material, so that it covers the upper surface of the deposit of the first material and the first material is etched so as to eliminate it at least from the walls of the spacers (10).

4. Process according to any one of the claims 1 to 3, characterized in that the spacers are made from silica.

5. Process according to claim 4, characterized in that the spacers are eliminated by hydrofluoric acid.

## Patentansprüche

1. Verfahren zum Herstellen von voneinander getrennten Elementen (11a, 13a) auf einem Substrat (1) mit einem ersten Schritt zum Herstellen von Abstandselementen (10) auf dem Substrat, die senkrecht zu dem Substrat in der Form kleiner Mauern sind, deren Flachen eben und parallel sind, deren Dimensionen und Abstände von den Dimensionen und dem Abstand der herzustellenden Elemente (11a, 13a) abhängen, dadurch gekennzeichnet, daß man danach auf dem Substrat eine anisotrope Abscheidung in eine Richtung senkrecht zur Substratoberfläche (1) von wenigstens einem die Elemente (11a) bildenden Material derart durchführt, daß die auf den Köpfen der Abstandselemente (10) ausgeführte Abscheidung der Abscheidung dieses ersten Materials auf den Wänden der Abstandselemente derart gegenübersteht, daß sie einen Querschnitt ovaler Form mit einer Breite größer als die Dicke der Abstandselemente (10) bildet, wobei die Wand der Abscheidung (11a) durch diese Tatsache eine zur vertikalen geneigte Schräge bildet, die von der ovalen Form der Abscheidungen (11b) bestimmt wird, und daß man dann die Abstandselemente entfernt.

2. Verfahren zum Herstellen von Elementen (11a, 13a) auf einem Substrat (1) nach Anspruch 1, dadurch gekennzeichnet, daß die Elemente Leiter sind.

3. Verfahren zum Herstellen von Elementen (11a, 13a) auf einem Substrat (1) nach Anspruch 1, dadurch gekennzeichnet, daß man zum Ausgleichen einer möglichen mangelhaften Anisotropie der Abscheidung des ersten Materials, die eine wenigstens teilweise Abscheidung des letzteren auf der Basis der Abstandselemente hervorruft, senkrecht zur Oberfläche des Substrats (1) eine anisotrope Abscheidung (13a) eines zweiten Material auf der Abscheidung des ersten Materials derart durchführt, daß es die obere Oberfläche der Abscheidung des ersten Materials bedeckt, und daß man der erste Material derart ätzt, daß man es wenigstens auf der Basis der Abstandselemente (10) entfernt.

4. Verfahren nach einem der Ansprüche 1 bis 3, dadurch gekennzeichnet, daß die Abstandselemente aus Silizid bestehen.

5. Verfahren nach Anspruch 4, dadurch gekennzeichnet, daß die Abstandselemente durch Flußsäure entfernt werden.

FIG. 1

FIG. 2

FIG. 3

FIG. 4

FIG. 5

FIG. 6

FIG. 7

FIG. 8

FIG 9

FIG. 10

FIG. 11

FIG. 12

FIG. 13